# EUROPEAN PATENT SPECIFICATION

(11) **EP 0 727 505 B1**
(45) Date of publication and mention of the grant of the patent: **19.08.1998**
(21) Application number: 96830032.7
(22) Date of filing: 26.01.1996
(51) Int. Cl.: C23C 14/10, C23C 14/06, C23C 14/56, B65D 65/40

(54) **Process for the codeposition of metallic oxides on a plastic film**
Verfahren zur Zusammenbeschichtung von Kunststoffilmen mit Metalloxiden
Procédé pour la codéposition des oxydes métalliques sur film plastique

(30) Priority: 01.02.1995 IT FI950019
(43) Date of publication of application: 21.08.1996
(73) Proprietor: GALILEO VACUUM TEC S.p.A., 50047 Prato (IT); CE.TE.V. CENTRO TECNOLOGIE DEL VUOTO, I-61067 Carsoli (AQ) (IT)
(72) Inventor: Fusi, Andrea, 50136 Firenze (IT); Misiano, Carlo, 00161 Roma (IT); Staffetti, Francesco, 67049 Tornimparte, Aquila (IT)
(74) Representative: Mannucci, Gianfranco, Dott.-Ing.

(56) References cited:
- EP-A- 0 460 796
- EP-A- 0 550 039
- EP-A- 0 656 430
- DE-B- 1 156 289
- GB-A- 2 259 524
- US-A- 2 907 679

## Description

### Technical Field

The invention relates to an improvement of a vacuum codeposition process for the formation of a dielectric layer on a plastic film.

Processes of this type are commonly used for the production of plastic films on which a dielectric barrier is provided, in order to make them impermeable to oxygen and moisture.

The invention also relates to a plastic film treated by this process.

### State of the Art

The technique of vacuum deposition presents considerable problems from the point of view of the conditions of evaporation, of the optical and aesthetic quality of the layer deposited on the film, and of the costs of the products employed for the deposition.

Currently, in order to obtain a product which provides a sufficient barrier to oxygen and to moisture and which at the same time has high transparency, silicon monoxide is employed. This material has the disadvantage of being extremely expensive. Furthermore, the plastic film treated with silicon monoxide acquires a yellowish coloration, which is particularly undesirable in the case of use of the film for the packaging of foodstuffs, in as much as the coloration of the plastic substrate hinders the correct perception of the optical characteristics of the product packaged with the film.

Attempts have also been made to use silicon dioxide, but this product has the disadvantage of not providing a sufficient barrier effect, especially against water vapour.

Recently, an innovative vacuum deposition process has been proposed in which there is performed, on the plastic film, a codeposition of a first material consisting of a sub-oxide resulting from the evaporation of an oxide which tends to dissociate, liberating oxygen, and of a second material consisting of a metal having a getter effect, which, during the deposition phase, combines with the oxygen liberated by the dissociation of the first material. Getter effect is to be understood as the physico-chemical property of certain metals of binding themselves to chemically active species, especially oxygen, thus being transformed into oxides.

This process is described in the Italian Patent Application no. FI92A106, filed on 14th May 1992, to which reference can be made for more detail. The first material is silicon dioxide or aluminium oxide and the second material is magnesium, barium, aluminium or an equivalent material. The process described in the abovementioned Italian Patent Application makes it possible to obtain, on the plastic material, a dielectric deposit consisting of mixed oxides of the getter metal (typically magnesium or aluminium) and of silicon (in the form of the sub-oxide). The codeposition makes it possible to obtain a number of advantages in terms of the economics of the process, the optical quality of the product and confidence in the barrier effect.

From EP-A-0 460 796 coating structures on polymeric substrates as well as methods for obtaining them are disclosed. According to this prior art, an SiO₂ coating is doped with one or more certain metals, such as Sb, Al, Mn and others. A variation of the composition along the thickness of the deposited coating is not disclosed.

### Summary of the Invention

The process described in Patent Application FI92A106 has now been improved for further enhancement of the end result, in particular in terms of enhanced barrier effect.

Essentially, the process according to the present invention provides for the vacuum deposition, on the plastic film, of a layer having a composition which is variable along its thickness, with a decreasing percentage of a getter-effect metal and/or of its compounds from the interface between the deposit and the film towards the outer surface of the deposit, and an increasing percentage of the sub-oxide from the interface between the deposit and the film towards the outer surface of the deposit, or vice versa.

It is possible to obtain a deposit having variable composition in the abovementioned manner by arranging, in a single deposition chamber and in series, a first source of evaporation of the getter-effect metal and a second source of evaporation of the oxide. In the case of the percentage of metal decreasing from the interface towards the outside, the said first source is located upstream of the second source with respect to the direction of advance of the plastic film which is to be treated.

The getter-effect metal can be present along the entire thickness of the deposit in the form of oxide. Nevertheless, it has been found that, with an opportune arrangement of the sources and with the appropriate ratio of the evaporating quantities of oxide and of metal, it is possible to obtain, in proximity to the interface between film and deposit, a percentage of getter-effect metal in a partially oxidized form. The fact that the metal in part deposits in a partially oxidized form makes it possible to obtain further advantages with respect to the codeposition of totally oxidized mixed oxides having a variable composition along the thickness of the deposit. The presence of partially oxidized metal on the interface between deposit and plastic film is obtained by a deposition having a decreasing percentage of metal from the said interface towards the outside, rather than vice versa. This solution is therefore in fact preferred.

The presence of only partially oxidized metal in proximity to or in contact with the plastic film augments the barrier effect against water vapour and oxygen. The possible explanations for this improvement are both of a chemical nature and a physical nature. In the first place, the small metallic aggregates which form in the vicinity of the plastic film or directly on its surface modify the microstructure of the deposit and thus increase the density and the compactness, which favours a growth of amorphous rather than crystalline type. This reduces the formation of column structures which are typically encountered in these deposition techniques and which reduce the barrier effect. Consequently, there is a reduction of interstitial voids which favour the diffusion of the permeant (water vapour or oxygen) from the outer surface of the deposit towards the plastic film. Further beneficial effects deriving from the presence of metallic nuclei in the deposit can be ascribable to a reduction in the polar effects which favour the adsorption of water molecules at the surfaces and a possible reduction in the solubility of the permeant in the deposit. This effect is present even in the case in which the percentage of metal increases from the interface between film and deposit and the outer surface of the deposit.

Advantageously, and in a manner known per se, it is possible to use silicon dioxide or alumina as the oxide tending to dissociate and to use magnesium, barium or preferably aluminium as the metal having a getter effect.

In the evaporation of silicon dioxide (SiO₂), the latter tends to dissociate, liberating oxygen, and deposits as SiOₓ, with x being variable between 1 and 2 according to the process parameters adopted (power density employed for the evaporation of the dioxide, evaporation rate of the getter metal, degree of vacuum). Optimum results are obtained with x being equal to about 1.5.

The invention also relates to a plastic film with - at least on one face - a thin deposit of a dielectric material of mixed oxides, obtained by vacuum deposition, which comprise at least one sub-oxide obtained from an oxide tending to dissociate, liberating oxygen, and an oxide of a getter metal.

According to the invention, the percentages of sub-oxide and of getter metal and of its compounds are variable along the thickness of the deposit from the interface between film and deposit towards the outer surface. Preferably, starting from the interface, the percentage of sub-oxide increases and the percentage of metal and/or of its compounds decreases.

### Brief Description of the Drawings

The invention will be better understood by following the description and the attached drawing, which shows a non-limiting exemplary embodiment of this invention. In the drawing:
Figure 1 shows a sketch of the apparatus for carrying out the process according to the invention; and
Figures 2A, 2B and 2C show diagrams of the results of the analysis carried out on plastic films which have been treated by the process according to the invention.

### Detailed Description of the Invention

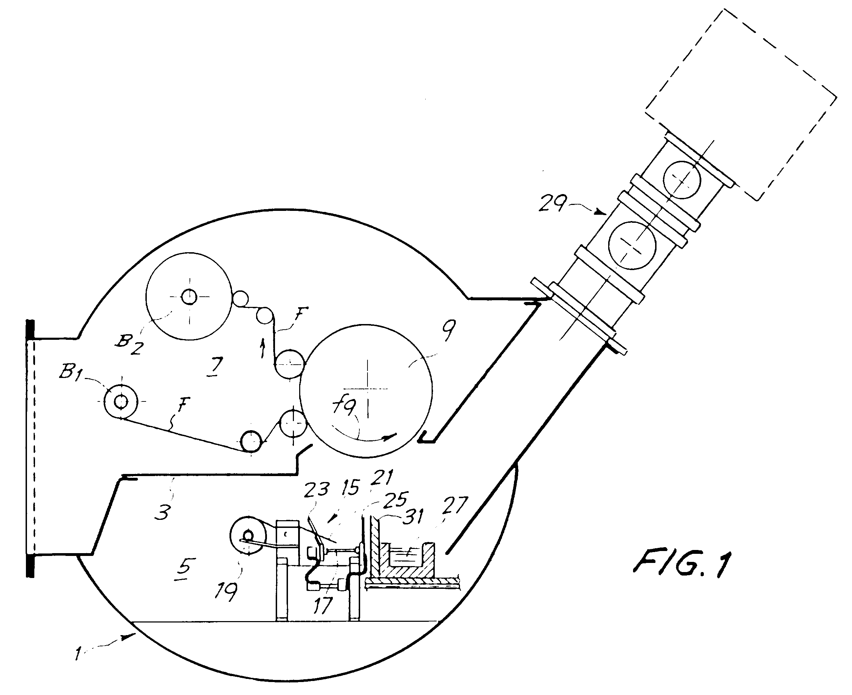

Referring to Figure 1, the evaporation chamber, divided by a partition 3 into two half-chambers, is indicated generically by 1: the lower half-chamber 5, which is designated below as deposition chamber, contains the evaporation sources which will be described below; the upper half-chamber 7 houses a reel B1 from which the plastic film F which is to be treated unwinds and a reel B2 on which the treated film is wound up. The film F is passed round a drum or roll 9 rotating in the direction f9, the lower part thereof protruding into the interior of the deposition chamber 5.

The two half-chambers 5 and 7 are connected in a manner known per se to vacuum pumps which are not shown and which ensure in the respective half-chambers a sufficient degree of vacuum, which is normally taken further in the lower deposition chamber 5 in order to facilitate the evaporation of the materials which form the deposit.

In the deposition chamber 5, a first evaporation source, generically designated by 15, is located in which aluminium, magnesium or another metal having a getter effect is evaporated. The source consists of a plurality of single sources 17 heated by the Joule effect, each fed by a metal wire 21 wound on a respective guide reel 19. The source 15 is associated with screens 23, 25, which delimit the lobe of evaporation and direct it to the lower part of the drum 9.

Downstream of the source 15, with respect to the direction of advance of the plastic film F coming from the drum 9, a second source, generically designated by 27, is located. Said second source is (in the example illustrated) an electron beam gun source of the "Pierce" type and serves to evaporate the silicon dioxide or another equivalent oxide tending to dissociate, liberating oxygen. Other types of electron beam guns can also be used. 29 generically indicates the electron beam gun which is arranged outside the deposition chamber 5 and will not be described in more detail, since it is of a type known per se.

A partition wall 31 prevents direct mutual visibility of the sources 15 and 27.

As will be clear from the schematic representation in Figure 1 for the purpose of a superposition of the evaporation zones of the oxide and of the getter metal, the film F initially passes through a zone in which the presence of metal originating from the source 15 predominates, while afterwards (following the advance) it passes through a zone where the presence of oxide predominates. Consequently, the layer of deposited dielectric shows a composition which is variable from the outer surface (where the presence of silicon oxide predominates) towards the inner surface, that is to say to the interface between the dielectric deposit and the plastic film (where the presence of the oxide of the getter metal predominates).

The process parameters preferred in practice for the codeposition of mixed oxides with the use of SiO₂ as the oxide tending to dissociate and Al as the getter metal are as follows:
- speed of advance of the plastic substrate: 3-4 m/s,
- rate of deposition: 3000-4000 Ångström/s,
- thicknesss of the deposited layer: 500-700 Ångström,
- quantity of aluminium evaporated per source: 2-3 g/minute,
- power density for the evaporation of SiO₂: 0.3-0.6 kW/cm²,
- evaporating SiO₂ surface area corresponding to each source of Al: 40-50 cm²,
- optimum residual pressure: 3x10⁻⁴ - 7x10⁻⁴ mbar.

The film thus treated was analyzed by the technique of SNMS (Secondary Neutral Mass Spectrometry) analysis for analyzing the composition of the deposition layer at various depths of the deposit. The SNMS analysis technique is a technique known per se and will not be described here in detail. In the present case it was carried out using instrumentation from VG Scientific (Model SIMS LAB 3 B equipped with OPTIONAL SNMS), in which the surface of the deposit to be analyzed is bombarded with a beam of oxygen ions. The bombardment generates an emission of ions and secondary neutral elements reemitted from the surface of the deposit. The reemitted material is for the most part neutral (more than 90%). The SNMS technique employed serves to post-ionize in the gaseous phase the neutral elements emitted from the layer deposited on the plastic film and to analyze by quadripolar mass spectrometry.

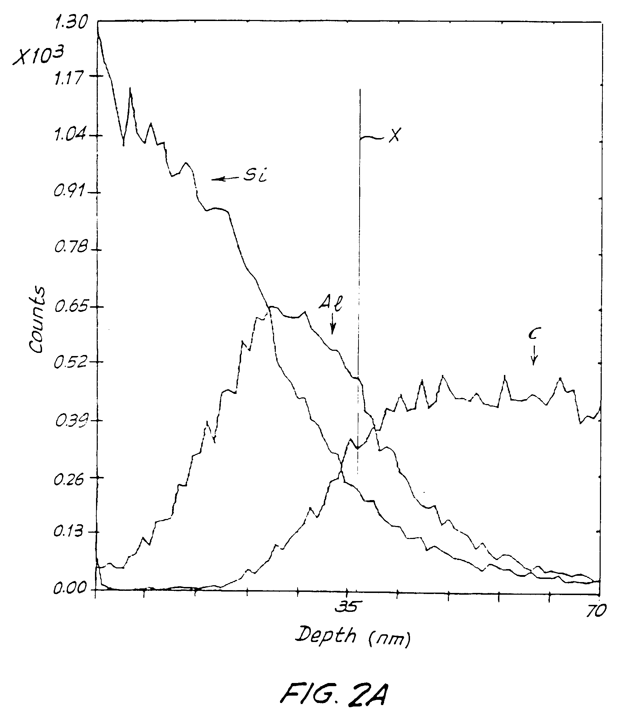

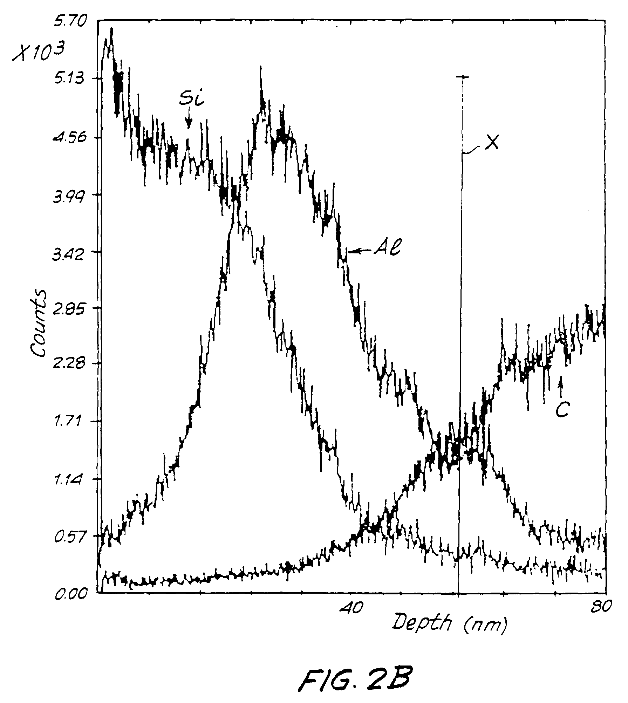

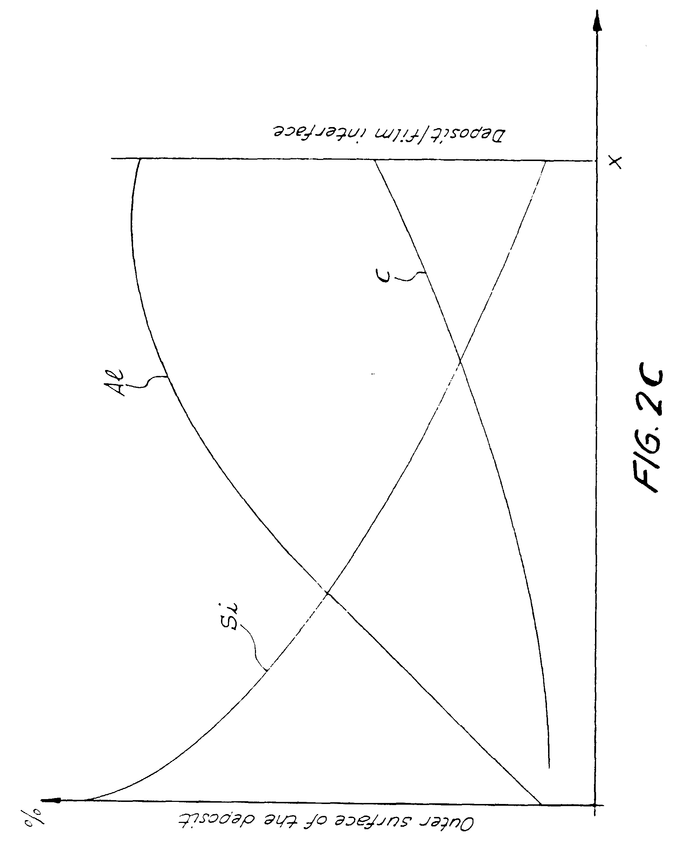

The results of the analyses are plotted for two different specimens in Figures 2A and 2B. The two specimens differ by the different quantities of evaporated aluminium (more in the specimen of the diagram in Figure 2B) and by the different depth or thickness of the deposit (about 35 nm for the specimen of Figure 2A and about 55 nm for the specimen of Figure.2B). The depth of the deposited thickness is plotted as abscissa. The origin corresponds to the outer surface of the deposit, while X indicates the interface between the deposit and the surface of the film F.

In both diagrams, the values corresponding to the curves for Al and Si can be interpreted as sensitivity factors which are directly proportional to the quantities of Si and Al present (in the form of the respective oxides or suboxides) at various depths of the deposit. The diagrams can therefore be read as being indicative of the relative percentages of the respective compounds of aluminium and silicon which are present in the layer deposited on the plastic film. This interpretation is valid up to a certain minimum distance from the interface between deposit and film. In fact, if the material of the matrix of the deposit is only partially oxidized (and hence, if the getter metal is in part present in the metallic form as well as in the oxidized form), the sensitivity factors and above all the sputtering yield change, so that the curves no longer give quantitatively significant values.

In the present case, starting from the outer surface of the deposit, a substantially monotonic decreasing trend in the quantity of silicon compounds and a trend increasing from a minimum to a maximum in the quantity of aluminium oxide, in an intermediate position between the outer surface of the deposit and the deposit/film interface, are observed in both the diagrams. The maximum in the curve corresponding to the quantity of aluminium compound is nearer to the deposit/film interface in the diagram of Figure 2A, that is to say in the specimen obtained with a smaller quantity of evaporated aluminium relative to the quantity of silicon dioxide. The curve corresponding to the aluminium has a decreasing trend from the maximum up to the deposit/film interface. This trend is explicable in the following way: in the vicinity of the deposit/film interface, the aluminium is present in part in the metallic, that is to say nonoxidized form. This percentage of nonoxidized aluminium is not detected quantitatively by the SNMS system. The trend of the curve corresponding to aluminium therefore indicates that, in proximity to the deposit/film interface, the quantity of oxidized aluminium diminishes because of the presence of nonoxidized aluminium.

As is found by comparing the diagrams of Figures 2A and 2B, the maximum in the curve corresponding to the presence of aluminium oxide is further away from the deposit/film interface in the case where a larger quantity of aluminium is evaporated. This is perfectly consistent with the interpretation, given above, of the non-monotonic trend of the curve corresponding to the aluminium: the greater the quantity of evaporated aluminium, the greater is the quantity of this material present in the nonoxidized form and the greater will therefore be the span of the descending curve of the aluminium in the diagram obtained by SNMS analysis.

On the basis of the results obtained with the SNMS analysis, and taking account of the presence of aluminium in the nonoxidized form, a qualitative graph of the percentage of Si and Al as a function of the depth of the deposit can be plotted. This qualitative graph is shown in Figure 2C. The curve for Al in Figure 2C takes account of the global presence of aluminium in both the oxidized and metallic forms.

In the three diagrams of Figures 2A, 2B and 2C, a curve C corresponding to the presence (detectable by the SNMS analysis) of carbon is also indicated. The presence of this element has not been unequivocally clarified, but it has also been found in other codeposition systems. According to one possible interpretation, these are carbon atoms which have been released from the plastic substrate itself on which the deposition is carried out. On the other hand, this minimal percentage of carbon does not impair the optical characteristics and barrier characteristics of the deposit.

From the analyses of the layer deposited in accordance with the process of the present invention, it is definitely established that the deposit is characterized:
a) by a variable trend in the percentages of aluminium and silicon, in the form of the respective oxides, with the percentage of silicon decreasing and the percentage of aluminium increasing from the outer surface to the deposit/film interface;
b) by the presence of nonoxidized metal in the vicinity of the deposit/film interface.

These characteristics provide an enhancement to the properties of the end product, as demonstrated above.

It is to be understood that the drawing shows merely an exemplary embodiment, given solely as a demonstration of the invention in practice, it being possible for this invention to be varied in its forms and arrangements, without otherwise departing from the scope of the following claims. The occasional presence of reference numbers in the attached claims has the purpose of facilitating the reading of these claims with reference to the description and to the drawing, and it does not limit the scope of the protection which is represented by the claims.

## Claims

1. Process for the production of a plastic film having a dielectric deposit of vacuum-deposited mixed oxides, in which there is performed, on the said plastic film, a codeposition of a first material consisting of a sub-oxide resulting from the evaporation of at least one oxide which tends to dissociate, liberating oxygen, and of a second material consisting of at least one oxide of a metal having a getter effect, characterized by the deposition of a layer having a variable composition along the thickness of the layer itself, with a variable percentage of said getter-effect metal and/or of its compounds from the interface between the deposit and the film towards the outer surface of the deposit and with a variable percentage of said sub-oxide in the inverse direction from the interface between the deposit and the film towards the outer surface of the deposit.

2. Process according to Claim 1, characterized in that the percentage of said getter-effect metal and/or of its compounds decreases along the thickness of the deposited layer from the interface between the deposited layer and the film towards the outer surface, while the percentage of said sub-oxide increases from said interface towards said outer surface.

3. Process according to Claim 2, characterized by an arrangement in series of a first source of said metal and a second source of said oxide, said first source being located upstream of said second source with respect to the direction of advance of the plastic film which is to be treated.

4. Process according to Claim 2 or 3, characterized in that a percentage of said getter-effect metal is deposited in a partially oxidized form in proximity to said interface.

5. Process according to one or more of the preceding claims, characterized in that said oxide tending to dissociate is silicon dioxide or alumina and that said getter-effect metal is aluminium or magnesium or barium.

6. Process according to Claim 5, wherein said sub-oxide is of the formula SiOₓ with x being between 1 and 2 and preferably x being equal to 1.5.

7. Plastic film having, on at least one face, a thin deposit, obtained by vacuum deposition, of dielectric material consisting of mixed oxides, said mixed oxides comprising at least one sub-oxide, obtained from an oxide tending to dissociate, liberating oxygen, and an oxide of a getter-effect metal, characterized in that the percentage of said sub-oxide varies along the thickness of the dielectric layer from the interface between the film and the deposit towards the outer surface of the deposit, and that the percentage of said getter-effect metal and/or of its compounds varies in the inverse direction from said interface towards said outer surface.

8. Plastic film according to Claim 7, characterized in that the percentage of said sub-oxide increases along the thickness of said layer from the interface towards the outer surface, and the percentage of said metal and/or its compounds decreases from the interface towards the outer surface. 8

9. Plastic film according to Claim 8, characterized in that said getter-effect metal is present at least in part in a partially oxidized form in proximity to said interface.

10. Plastic film according to Claim 7, 8 or 9, characterized in that said sub-oxide is a sub-oxide of silicon of the formula SiOₓ, with x being between 1 and 2 and preferably being equal to 1.5, and that said getter-effect metal is aluminium or magnesium or barium.

## Patentansprüche

1. Verfahren zur Herstellung einer Plastikfolie mit einer dielektrischen Beschichtung aus im Vakuum abgeschiedenen gemischten Oxiden, bei dem auf der Plastikfolie eine gemeinsame Abscheidung eines ersten Materials, bestehend aus einem Suboxid, das sich aus der Verdampfung mindestens eines zur Dissoziierung unter Freisetzung von Sauerstoff neigenden Oxids ergibt, und eines zweiten Materials, das aus mindestens einem Oxid eines Metalls mit Gettereffekt besteht, durchgeführt wird,
**gekennzeichnet** durch die Abscheidung einer Schicht mit einer über die Dicke der Schicht veränderlichen Zusammensetzung, mit einem variblen Prozentsatz des Gettereffekt-Metalls und/oder seiner Verbindungen von der Grenzfläche zwischen der Beschichtung und der Folie zur Außenfläche der Beschichtung und mit einem variablen Prozentsatz des Suboxids in der entgegengesetzten Richtung von der Grenzfläche zwischen Beschichtung und Folie zur Außenfläche der Beschichtung.

2. Verfahren nach Anspruch 1,
dadurch **gekennzeichnet,** daß der Prozentsatz des Gettereffekt-Metalls und/oder seiner Verbindungen über die Dicke der Beschichtungsschicht von der Grenzfläche zwischen der Beschichtungsschicht und der Folie zur Außenfläche hin abnimmt, während der Prozentsatz des Suboxids von der Grenzfläche zur Außenfläche hin zunimmt.

3. Verfahren nach Anspruch 2,
**gekennzeichnet** durch eine Serienanordnung einer ersten Quelle für das Metall und einer zweiten Quelle für das Oxid, wobei die erste Quelle vor der zweiten Quelle im Bezug auf die Vorschubrichtung der zu behandelnden Plastikfolie angeordnet ist.

4. Verfahren nach Anspruch 2 oder 3,
dadurch **gekennzeichnet,** daß ein Teil des Gettereffekt-Metalls in teilweise oxidierter Form in der Nähe der Grenzfläche abgeschieden wird.

5. Verfahren nach einem oder mehreren der vorangehenden Ansprüche,
dadurch **gekennzeichnet,** daß das zur Dissoziierung neigende Oxid Siliziumdioxid oder Aluminiumdioxid ist und daß das Gettereffekt-Metall Aluminium oder Magnesium oder Barium ist.

6. Verfahren nach Anspruch 5,
bei dem das Suboxid die Formel SiOₓ hat, wobei x zwischen 1 und 2 liegt und vorzugsweise gleich 1,5 ist.

7. Kunststoffolie, die auf mindestens einer Fläche eine durch Vakuumabscheidung erhaltene dünne Beschichtung von aus gemischten Oxiden bestehendem dielektrischen Material aufweist, wobei die gemischten Oxide mindestens ein Suboxid, das aus einem zur Dissoziierung unter Freisetzung von Sauerstoff neigenden Oxid erhalten ist, und ein Oxid eines Gettereffektmetalls umfassen,
dadurch **gekennzeichnet,** daß der Prozentsatz des Suboxids sich über die Dicke der dielektrischen Schicht von der Grenzfläche zwischen der Folie und der Beschichtung zur Außenfläche der Beschichtung hin ändert und daß der Prozentsatz des Gettereffekt-Metalls und/oder seiner Verbindungen sich in entgegengesetzter Richtung von der Grenzfläche zur Außenfläche hin ändert.

8. Plastikfolie nach Anspruch 7,
dadurch **gekennzeichnet,** daß der Prozentsatz des Suboxids über die Dicke der Schicht von der Grenzfläche zur Außenfläche hin zunimmt und der Prozentsatz des Metalls und/oder seiner Verbindungen von der Grenzfläche zur Außenfläche hin abnimmt.

9. Plastikfolie nach Anspruch 8,
dadurch **gekennzeichnet,** daß das Gettereffekt-Metall mindestens zum Teil in einer teilweise oxidierten Form in der Nähe der Grenzfläche vorliegt.

10. Plastikfolie nach Anspruch 7, 8 oder 9,
dadurch **gekennzeichnet,** daß das Suboxid ein Suboxid von Silizium der Formel SiOₓ ist, wobei x zwischen 1 und 2 liegt und vorzugsweise gleich 1,5 ist, und daß das Gettereffekt-Metall Aluminium oder Magnesium oder Barium ist.

## Revendications

1. Procédé pour la production d'un film plastique avec un dépôt diélectrique d'oxydes mélangés déposés sous vide, procédé dans lequel sur le film plastique on dépose conjointement un premier matériau constitué par un sous-oxyde résultant de l'évaporation d'au moins un oxyde qui tend à se dissocier, libérant de l'oxygène, et un second matériau constitué par au moins un oxyde d'un métal ayant un effet getter, caractérisé par le fait de déposer une couche ayant une composition variable sur l'épaisseur de la couche elle-même avec un pourcentage variable de métal à effet getter et/ou de ses composés à partir de l'interface entre le dépôt et le film en direction de la surface extérieure du dépôt et avec un pourcentage variable de sous-oxydes dans la direction inverse à partir de l'interface entre le dépôt et le film en direction de la surface extérieure du dépôt.

2. Procédé selon la revendication 1, caractérisé en ce que le pourcentage de métal à effet getter et/ou de ses composés diminue le long de l'épaisseur de la couche déposée en partant de l'interface entre la couche déposée et le film en direction de la surface extérieure tandis que le pourcentage du sous-oxyde augmente à partir de l'interface en direction de la surface extérieure.

3. Procédé selon la revendication 2, caractérisé par un agencement en série d'une première source de métal et d'une seconde source d'oxyde, la première source étant située en amont de la seconde source par rapport à la direction de déplacement du film plastique qui doit être traité.

4. Procédé selon la revendication 2 ou 3, caractérisé en ce que l'on dépose un pourcentage de métal à effet getter dans une forme partiellement oxydée à proximité de l'interface.

5. Procédé selon une ou plusieurs des revendications précédentes, caractérisé en ce que l'oxyde tendant à se dissocier est le dioxyde de silicium ou l'alumine et en ce que le métal à effet getter est de l'aluminium ou du magnésium ou du baryum.

6. Procédé selon la revendication 5, dans lequel le sous-oxyde est de formule SiOₓ, x étant entre 1 et 2 et de préférence x étant égal à 1,5.

7. Film plastique ayant sur au moins une face un mince dépôt obtenu par dépôt sous vide de matériau diélectrique consistant en des oxydes mélangés, ces oxydes mélangés comprenant au moins un sous-oxyde obtenu à partir d'un oxyde ayant tendance à se dissocier libérant de l'oxygène et un oxyde d'un métal à effet getter, caractérisé en ce que le pourcentage du sous-oxyde varie le long de l'épaisseur de la couche diélectrique à partir de l'interface entre le film et le dépôt en direction de la surface extérieure du dépôt et en ce que le pourcentage du métal à effet getter et/ou de ses composés varie dans la direction inverse en partant de l'interface en direction de la surface extérieure.

8. Film plastique selon la revendication 7, caractérisé en ce que le pourcentage du sous-oxyde augmente le long de l'épaisseur de la couche à partir de l'interface en direction de la surface extérieure et le pourcentage de ce métal et/ou de ses composés diminue en partant de l'interface en direction de la surface extérieure.

9. Film plastique selon la revendication 8, caractérisé en ce que le métal à effet getter est présent au moins en partie dans une forme partiellement oxydée à proximité de l'interface.

10. Film plastique selon la revendication 7, 8 ou 9, caractérisé en ce que le sous-oxyde est un sous-oxyde de silicium de la formule SiOₓ, x étant entre 1 et 2 et de préférence égal à 1,5 et en ce que le métal à effet getter est de l'aluminium ou du magnésium ou du baryum.
